# EUROPÄISCHE PATENTANMELDUNG

(11) **EP 4 109 682 A1**
(43) Veröffentlichungstag der Anmeldung: **28.12.2022**
(21) Anmeldenummer: 22181086.4
(22) Anmeldetag: 24.06.2022
(51) Int. Cl.: H01R 12/58, H05K 1/16, H05K 1/02, H01R 13/6466, H05K 1/14, H01R 24/64

(54) **LEITERPLATTEN-STECKVERBINDER-EINHEIT MIT INTEGRIERTEN HF-KOPPELKAPAZITÄTEN UND VERFAHREN DAFÜR**

(30) Priorität: 24.06.2021 DE 102021116400
(71) Anmelder: Zellner GmbH, 94244 Teisnach (DE)
(72) Erfinder: Klees, Ernst, 80939 München (DE); Fuchs, Günther, 94244 Teisnach (DE)
(74) Vertreter: Farago-Schauer, Peter Andreas

(57) **Zusammenfassung**

Die vorliegende Erfindung betrifft eine Leiterplatten-Steckverbinder-Einheit mit integrierten HF-Koppelkapazitäten, die Folgendes umfasst: a) eine Steckverbindereinheit (2) mit mindestens zwei elastischen Federkontakten (3), die jeweils einen ersten Endabschnitt (3a), einen gegenüberliegenden zweiten Endabschnitt (3c) und einen dazwischenliegenden Berührungskontaktabschnitt (3b) aufweisen, wobei der jeweilige Federkontakt (3) so ausgebildet ist, dass der erste Endabschnitt (3a) mit einer Leiterplatte (1) elektrisch und mechanisch fest verbunden ist, wonach der Berührungskontaktabschnitt (3b) von der Leiterplatte (1) in einer Steckrichtung (x) und von der Leiterplatte (1) weg mit einem nach außen abstehenden Höcker gebogen und dabei elastisch ist, wobei der sich anschließende zweite Endabschnitt (3c) in der Steckrichtung (x) und zur Leiterplatte (1) hin zurückgebogen ist, um so zusammen mit der Leiterplatte (1) die Leiterplatten-Steckverbindereinheit zu bilden, die manuell mit einer dazu passenden Gegensteckverbindereinheit verbindbar und davon wieder lösbar ist; b) die Leiterplatte (1) mit Haltekontaktanschlüssen (4), die in einem ersten Leiterplattenabschnitt (1a) angeordnet und mit den jeweiligen ersten Endabschnitten (3a) der Federkontakte (3) elektromechanisch verbunden sind, wobei Endkontakte (7) in einem in der Steckrichtung (x) gegenüberliegenden zweiten Leiterplattenabschnitt (1b) angeordnet und durch mindestens eine Leiterbahn mit den dazugehörigen Haltekontaktanschlüssen (4) elektrisch verbunden sind; c) wobei (i) in der Leiterplatte (1) unter den zweiten Endabschnitten (3c) der Federkontakte (3) jeweilige HF-Kontaktanschlüsse (5) angeordnet sind, die über jeweilige Kontaktmittel (6) mit dem jeweiligen zweiten Endabschnitt (3c) elektrisch verbunden sind, oder wobei (ii) die Federkontakte (3) zu den jeweiligen HF-Kontaktanschlussen (5) derart angeordnet sind, dass bei einer Einfederung der Federkontakte (3), die bei der Verbindung der Leiterplatten-Steckverbinder-Einheit mit der Gegensteckverbindereinheit erfolgt, eine Kontaktierung der jeweiligen Endabschnitte (3c) mit den jeweiligen HF-Kontaktanschlüssen (5) über die jeweiligen Kontaktmittel (6) entsteht; d) wobei (i) in der Leiterplatte (1), die mehrere Lagen aufweist, mindestens zwei der HF-Kontaktanschlüsse (5) jeweils mit einer Kondensatorfläche (F1-F6) verbunden sind, die in übereinanderliegenden Lagen zumindest teilweise überlappend angeordnet sind, um die jeweilige entsprechende HF-Koppelkapazität zu einer HF-Kompensation zwischen den damit verbundenen Federkontakten (3) zu bilden, oder wobei (ii) in der Leiterplatte (1) mindestens zwei der HF-Kontaktanschlüsse (5) jeweils mit einem Kondensator verbunden sind, um die jeweilige entsprechende HF-Koppelkapazität zu einer HF-Kompensation zwischen den damit verbundenen Federkontakten (3) zu bilden, e) wobei die HF-Kontaktanschlüsse (5) als metallisierte Sacklöcher oder metallisierte Durchgangsbohrungen ausgebildet sind, die mit dem jeweiligen zweiten Endabschnitt (3c) durch die jeweiligen Kontaktmittel (6) elektrisch verbunden oder verbindbar sind, und f) wobei der jeweilige zweite Endabschnitt (3c) in das Sackloch oder die Durchgangsbohrung des dazugehörigen HF-Kontaktanschlusses (5) in das jeweilige Kontaktmittel (6) eintauchbar ist.

## Beschreibung

Die vorliegende Erfindung betrifft eine Leiterplatten-Steckverbinder-Einheit mit integrierten HF-Koppelkapazitäten nach dem Oberbegriff des Anspruchs 1 und ein Verfahren zur Herstellung dazu.

Leiterplatten-Steckverbinder-Einheiten können männliche Stecker oder weibliche Steckerbuchsen oder beispielsweise RJ45-Stecker oder -Steckbuchsen sein, die jeweils mit einer dazu passenden Gegensteckverbindereinheit verbindbar und davon lösbar sind, wobei die Gegensteckverbindereinheit dementsprechend eine Steckerbuchse oder ein Stecker ist. Die Leiterplatten-Steckverbinder-Einheiten umfassen Kontakte mit damit verbundenen Leitern, über die elektrische Signale und/oder ein Strom geleitet werden kann. Je nach Ausführung kann die jeweilige Leiterplatten-Steckverbinder-Einheit zwei bis zu einer Vielzahl von elektrischen Leitern und Kontakten enthalten. Beispielsweise kann die jeweilige Leiterplatten-Steckverbinder-Einheit in einem Elektronikgerät eingebaut und daran angeschlossen oder an einem Kabel mit entsprechenden Kabeladern angeschlossen sein.

Bekanntlich umfassen die Leiterplatten-Steckverbinder-Einheiten jeweils eine Leiterplatte mit einem ersten und einem gegenüberliegenden zweiten Leiterplattenabschnitt, wobei im ersten Leiterplattenabschnitt Haltekontaktanschlüsse angeordnet sind, die mechanisch und elektrisch mit einer Vielzahl an Federkontakten verbunden sind. Die Federkontakte sind ausgebildet, die elektrische Steckverbindung zur entsprechenden Gegensteckverbindereinheit herzustellen. Dabei sind die Federkontakte elastisch und weisen jeweils einen ersten Endabschnitt, einen gegenüberliegenden zweiten Endabschnitt und einen dazwischenliegenden Berührungskontaktabschnitt auf. Dabei wird der erste Endabschnitt mit der Leiterplatte elektrisch und mechanisch fest verbunden, wonach der Berührungskontaktabschnitt von der Leiterplatte in einer Steckrichtung und von der Leiterplatte weg mit einem nach außen abstehenden Höcker gebogen ist. Üblicherweise ist der Höcker auch die elektrische Kontaktstelle zu einem entsprechenden Kontakt der Gegensteckverbindereinheit.

Am zweiten Leiterplattenabschnitt sind eine entsprechende Vielzahl an Endkontakten angeordnet, die einerseits über die Leiter der Leiterplatte mit den dazugehörigen Haltekontaktanschlüssen und den Federkontakten verbunden sind und andererseits Kontaktstellen darstellen, mit denen beispielsweise eine Elektronik dauerfest verbindbar ist. Beispielsweise können mit den Endkontakten Schneidklemmkontakte für eine weitere elektrische Verbindung verbunden sein. Die Federkontakte sind dabei jeweils mit einem ersten Endabschnitt mit dem dazugehörigen Haltekontaktanschluss der Leiterplatte mechanisch fest verbunden.

Da eine Übertragungsgeschwindigkeit von Signalen eine immer größere Rolle spielt, müssen die Leiterplatten-Steckverbinder-Einheiten und Kabel mit internen Leitern immer besser an einen komplexen Übertragungswiderstand angepasst und daher HF-kompensiert werden. Um eine HF-Kompensation zwischen entsprechenden Leitern oder einem Leiterpaar vornehmen zu können, werden möglichst nahe den jeweiligen Kontaktenden dazwischen entsprechende HF-Koppelkapazitäten angeschlossen.

Dabei können die HF-Koppelkapazitäten als Kondensatoren beispielsweise auf oder in der Leiterplatte angeordnet sein. Bekanntlich kann in der Leiterplatte, die als mehrlagige Leiterplatte aufgebaut ist, zwischen den Leitern, zwischen denen die HF-Kompensation vorgenommen werden soll, eine entsprechende HF-Koppelkapazität so gebildet werden, dass mit den Leitern in übereinander angeordneten Lagen Leiterflächen verbunden werden, die zusammen einen Plattenkondensator mit einem dazwischen liegenden Dielektrikum als Leiterplattenmaterial bilden. Dabei ist es vorteilhaft, die übereinander angeordneten Leiterflächen möglichst nahe an den dazugehörigen Haltekontaktanschlüssen anzuordnen und damit zu verbinden. Jeder Millimeter weniger Abstand der HF-Koppelkapazitäten vom jeweiligen Kontaktpunkt des Federkontakts erhöht die Qualität der HF-Kompensation der Leiterplatten-Steckverbinder-Einheit.

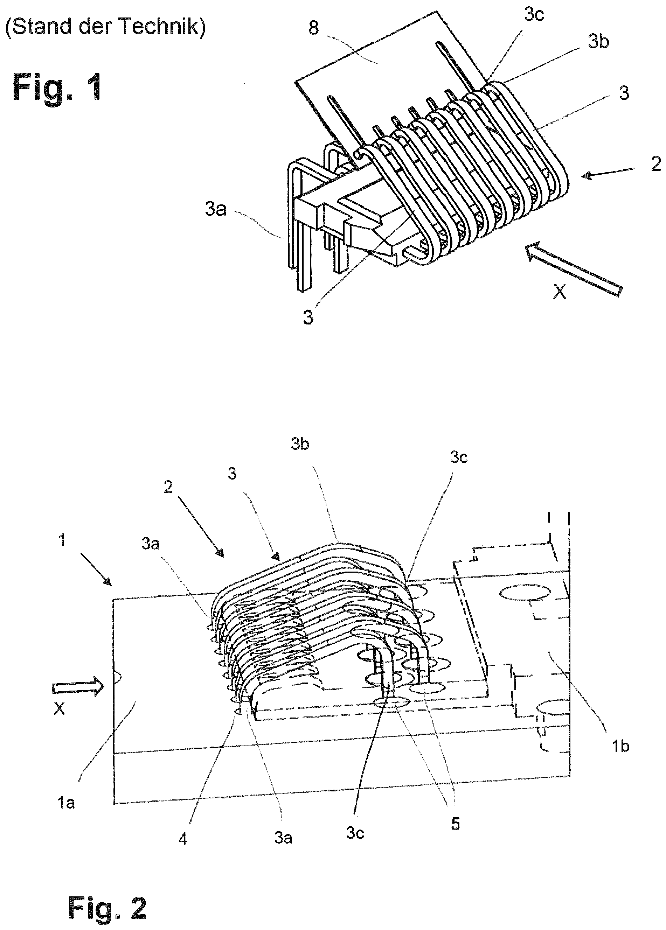

Bei einer anderen Leiterplatten-Steckverbinder-Einheit aus dem Stand der Technik von Bel-Stewart sind die HF-Koppelkapazitäten an den jeweiligen Federkontakten an einem zweiten Endabschnitt der Federkontakte angeordnet, wobei die zweiten Endabschnitte der Federkontakte ersten Endabschnitten, die jeweils mit den Haltekontaktanschlüssen der Leiterplatte verbunden sind, gegenüberliegen (siehe Fig. 1). Dabei sind die zweiten Enden mit einer flexiblen zusätzlichen Leiterplatte verbunden, die die HF-Koppelkapazitäten enthält. Der dabei entstehende mechanische Aufbau ist mechanisch empfindlich für einen Bruch der elektrischen Verbindung zwischen einem der zweiten Endabschnitte und der flexiblen zusätzlichen Leiterplatte und kostspielig; der Vorteil ist dabei jedoch, dass die HF-Koppelkapazitäten näher am elektrischen Kontaktpunkt des Federkontakts zur Gegensteckverbindereinheit sitzen, als wenn sie in der Boden-Leiterplatte angeordnet wären.

Eine weitere Anordnung aus dem Stand der Technik ist aus der EP 2 983 255 B1 bekannt, worin in einem Endbereich einer flexiblen Leiterplatte, einer Steckbuchse oder auch im Bereich einer Umbiegung der Leiterplatte, bevor die vereinzelten Leiterbahnabschnitte der Federfinger der Federkontakte beginnen, elektronische Kompensationsmittel oder Resonanzdämpfungsmittel eingebettet sind. Diese Mittel sind ebenfalls mit einem erheblichen Abstand von den Federfingern bzw. Federkontakten angeordnet. Zudem ist diese bekannte Anordnung mechanisch empfindlich, da eine Blattfeder zur Positionierung eines in die Buchse eingesteckten Steckers bereitgestellt ist. Somit kann insbesondere beim unsachgemäßen Einstecken eines Steckverbinders nur eine geringe Anzahl an Einsteckzyklen erzielt werden.

Aufgabe der Erfindung ist, die Nachteile aus dem Stand der Technik zu beseitigen und dabei eine Leiterplatten-Steckverbinder-Einheit bereitzustellen, die eine möglichst gute HF-Kompensation durch entsprechende HF-Koppelkapazitäten aufweisen soll und dabei auch möglichst robust und kostengünstig herstellbar sein soll.

Die vorstehende Aufgabe wird von einer Leiterplatten-Steckverbinder-Einheit gemäß den Merkmalen des unabhängigen Anspruchs 1 und einem Verfahren gemäß den Merkmalen des unabhängigen Anspruchs 8 gelöst. Weitere vorteilhafte Ausführungsformen der Erfindung sind in den abhängigen Ansprüchen angegeben.

Erfindungsgemäß wird eine Leiterplatten-Steckverbinder-Einheit mit integrierten HF-Koppelkapazitäten zur Verfügung gestellt, die Folgendes umfasst:
a) Eine Steckverbindereinheit mit mindestens zwei elastischen Federkontakten, die jeweils einen ersten Endabschnitt, einen gegenüberliegenden zweiten Endabschnitt und einen dazwischenliegenden Berührungskontaktabschnitt aufweisen, wobei der jeweilige Federkontakt so ausgebildet ist, dass der erste Endabschnitt mit einer Leiterplatte elektrisch und mechanisch fest verbunden ist, wonach der Berührungskontaktabschnitt von der Leiterplatte in einer Steckrichtung und von der Leiterplatte weg mit einem nach außen abstehenden Höcker gebogen und dabei elastisch ist, wobei der sich anschließende zweite Endabschnitt in der Steckrichtung und zur Leiterplatte hin zurückgebogen ist, um so zusammen mit der Leiterplatte die Leiterplatten-Steckverbindereinheit zu bilden, die manuell mit einer dazu passenden Gegensteckverbindereinheit verbindbar und davon wieder lösbar ist;
b) die Leiterplatte mit Haltekontaktanschlüssen, die in einem ersten Leiterplattenabschnitt angeordnet und mit den jeweiligen ersten Endabschnitten der Federkontakte elektromechanisch verbunden sind, wobei Endkontakte in einem in der Steckrichtung gegenüberliegenden zweiten Leiterplattenabschnitt angeordnet und durch mindestens eine Leiterbahn mit den dazugehörigen Haltekontaktanschlüssen elektrisch verbunden sind;
c) wobei (i) in der Leiterplatte unter den zweiten Endabschnitten der Federkontakte jeweilige HF-Kontaktanschlüsse angeordnet sind, die über jeweilige Kontaktmittel mit dem jeweiligen zweiten Endabschnitt elektrisch verbunden sind, oder wobei (ii) die Federkontakte zu den jeweiligen HF-Kontaktanschlüssen derart angeordnet sind, dass bei einer Einfederung der Federkontakte, die bei der Verbindung der Leiterplatten-Steckverbinder-Einheit mit der Gegensteckverbindereinheit erfolgt, eine Kontaktierung der jeweiligen Endabschnitte mit den jeweiligen HF-Kontaktanschlüssen über die jeweiligen Kontaktmittel entsteht;
d) wobei (i) in der Leiterplatte, die mehrere Lagen aufweist, mindestens zwei der HF-Kontaktanschlüsse jeweils mit einer Kondensatorfläche verbunden sind, die in übereinanderliegenden Lagen zumindest teilweise überlappend angeordnet sind, um die jeweilige entsprechende HF-Koppelkapazität zu einer HF-Kompensation zwischen den damit verbundenen Federkontakten zu bilden, oder wobei (ii) in der Leiterplatte mindestens zwei der HF-Kontaktanschlüsse jeweils mit einem Kondensator verbunden sind, um die jeweilige entsprechende HF-Koppelkapazität zu einer HF-Kompensation zwischen den damit verbundenen Federkontakten zu bilden,
e) wobei die HF-Kontaktanschlüsse als metallisierte Sacklöcher oder metallisierte Durchgangsbohrungen ausgebildet sind, die mit dem jeweiligen zweiten Endabschnitt durch die jeweiligen Kontaktmittel elektrisch verbunden oder verbindbar sind, und
f) wobei der jeweilige zweite Endabschnitt in das Sackloch oder die Durchgangsbohrung des dazugehörigen HF-Kontaktanschlusses in das jeweilige Kontaktmittel eintauchbar ist.

Zur Klarheit sind die Kondensatorflächen als Leiterplattenflächen in einer jeweiligen Lage der Leiterplatte ausgebildet, so dass der Kondensator zwischen den Leiterplattenflächen und dem Basismaterial der dazwischenliegenden Leiterplatte als Dielektrikum gebildet wird. Das Basismaterial ist üblicher Weise aus Kunstharz ausgebildet. Alternativ dazu kann der Kondensator nach dem Funktionsprinzip der Nutzung inkrementeller Kapazität ausgebildet werden und in dieser Ausführungsform kann die Leiterplatte einlagig aufgebaut sein.

Zur Klarheit ist mit der Anordnung der HF-Kontaktanschlüsse in der Leiterplatte unter den zweiten Endabschnitten gemeint, dass die HF-Kontaktanschlüsse im Wesentlichen senkrecht unter den zweiten Endabschnitten zur Leiterplatte hin angeordnet sind, so dass die zweiten Endabschnitte die HF-Kontaktanschlüsse kontaktieren können.

Darüber hinaus ist erfindungsgemäß der Begriff "Leiterplatte" dahingehend zu verstehen, dass die Leiterplatte aus einer einzigen Leiterplatte oder aus einem Verbund von mindestens zwei Leiterplatten besteht, die miteinander verbunden sind.

Durch die Anordnung der jeweiligen Kondensatorflächen bzw. des Kondensators an den zweiten Endabschnitten der jeweiligen Federkontakte liegen die dabei entstehenden Koppelkapazitäten wesentlich näher am jeweiligen Berührungskontaktabschnitt und insbesondere am Höcker, als wenn die Kondensatorflächen bzw. der Kondensator, wie üblich, mit den ersten Endabschnitten der Federkontakte verbunden wären. Dadurch wird die HF-Kompensation merklich verbessert, wobei der mechanische Aufbau der Leiterplatten-Steckverbinder-Einheit robust und kostengünstig bleibt. Indem keine separate Leiterplatte wie im Stand der Technik gemäß Fig. 1 verwendet zu werden braucht, wird der Aufbau der Leiterplatten-Steckverbinder-Einheit wesentlich robuster und kostengünstiger.

Bevorzugt ist der jeweilige Federkontakt in der Steckrichtung so gebogen, dass eine erste Länge des Federkontakts, die zwischen dem Haltekontaktanschluss und dem Höcker bestimmt ist, größer ist als eine zweite Länge des Federkontakts, die zwischen dem Höcker und dem HF-Kontaktanschluss bestimmt ist. Bevorzugt liegt der Höcker in einer Mitte des Berührungskontaktabschnitts. Bevorzugt ist der Höcker auch der Berührungskontakt zu einem Gegenkontakt in der Gegensteckverbindereinheit. Bevorzugt ist der dazwischenliegende Berührungskontaktabschnitt höckerartig zu einer elektrischen Kontaktierung eines entsprechenden Gegenkontakts der Gegensteckverbindereinheit ausgebildet.

Bevorzugt sind die Kontaktanschlüsse Kontaktleiterflächen oder Pads oder Lötkontaktleiterflächen oder Kontaktlöcher, an oder in denen die Federkontakte angepresst, angelötet, eingelötet oder eingeklemmt werden.

Die Steckverbindereinheit kann entweder ohne oder mit einem zusätzlichen Halter- oder Führungsteil für die Federkontakte ausgebildet sein. Beispielsweise können die Federkontakte teilweise in das Halter- oder Führungsteil eingegossen sein, um die Montage mit der Leiterplatte zu vereinfachen. Andererseits kann das Halter- oder Führungsteil auch ausgebildet sein, die Federkontakte bei einem Einfedern bei einem Verbinden mit der Gegensteckverbindereinheit zu führen. Das Halter- oder Führungsteil kann auch ausgebildet sein, die zweiten Endabschnitte der Federkontakte zu den dazugehörigen HF-Kontaktanschlüssen zu führen. Bevorzugt ist das Halter- oder Führungsteil dabei nicht-leitend und im Wesentlichen aus Kunststoff. Die Federkontakte können aber auch einzeln als Einzelkontakte mit den Haltekontaktanschlüssen der Leiterplatte verbunden werden, beispielsweise durch ein Einpressen, ein Einlöten, ein Anpressen oder Kleben mit einem Leitkleber. Die Federkontakte sind elektrisch leitfähig und bevorzugt aus Metall, wie beispielsweise aus einer Kupfer- oder Silberlegierung oder aus einem Edelstahl. Bevorzugt sind die Federkontakte vergoldet oder versilbert.

Bevorzugt taucht der jeweilige zweite Endabschnitt in das Sackloch oder die Durchgangsbohrung des dazugehörigen HF-Kontaktanschlusses ein, zumindest während eines Einfederns des jeweiligen Federkontakts in einem Zustand einer Verbindung der Leiterplatten-Steckverbinder-Einheit mit der Gegensteckverbindereinheit. Die Löcher oder Sacklöcher sind dabei bevorzugt elektrisch leitend ausgebildet.

Bevorzugt ist der jeweilige zweite Endabschnitt gegen den dazugehörigen HF-Kontaktanschluss mechanisch verschiebbar und/oder darin eintauchbar, so dass der zweite Endabschnitt in Richtung zum HF-Kontaktanschluss in verschiedene Tiefen eintauchbar ist. Dabei kann der zweite Endabschnitt des Federkontakts auch einen Schleifkontakt mit dem HF-Kontaktanschluss aufweisen, wobei das Kontaktmittel der Schleifkontakt ist.

Bevorzugt ist der Federkontakt so ausgebildet, dass der Endabschnitt gegen den oder in den dazugehörigen HF-Kontaktanschluss mit einem Federweg bewegbar oder hineinfederbar ist. Dabei beträgt der Federweg bevorzugt 0,1 - 0,3 mm oder 0,3 - 0,5 mm oder 0,5 - 0,7 mm oder 0,7 - 0,9 mm oder bis 2 mm. Aufgrund des Federwegs können erfindungsgemäß vorteilhaft Gegensteckverbindereinheiten mit gewissen Größenabweichungen aufgenommen werden, so dass die Leiterplatten-Steckverbindereinheit einer größeren Anzahl von Steckvorgängen oder Einsteckzyklen ohne Beschädigung widersteht. Zusätzlich wird durch den Federweg der elektrische Kontakt zwischen der Leiterplatten-Steckverbindereinheit und der Gegensteckverbindereinheit verbessert.

Denkbar ist auch, dass die HF-Kontaktanschlüsse als Leiterpads auf der Leiterplatte ausgebildet sind, die von den zweiten Endabschnitten der Federkontakte kontaktiert werden. Dazu kann es vorteilhaft sein, wenn der jeweilige zweite Endabschnitt mit dem dazugehörigen HF-Kontaktanschluss elektromechanisch fest verbunden ist.

Bevorzugt wird als das Kontaktmittel eine Leitpaste oder eine HF-Leitpaste verwendet, die in das Sackloch, das Loch oder auf das Kontaktpad des jeweiligen HF-Kontaktanschlusses eingebracht oder aufgebracht wird. Bevorzugt ist das Kontaktmittel nach einem Ein- oder Aufbringen in/auf die Kontaktanschlüsse dauerelastisch oder pastös. Bevorzugt kann das jeweilige Kontaktmittel auch ein Leitgummi sein. Bevorzugt enthält das Kontaktmittel Kupfer- und/oder Silberpartikel oder andere elektrisch leitende Partikel, die eine gute HF-Leitfähigkeit besitzen. Bevorzugt ist die Leitpaste oder das Kontaktmittel ausgebildet, eine gute Haft- und Kontaktfähigkeit sowohl mit dem zweiten Endabschnitt des Federkontakts als auch mit dem HF-Kontaktanschluss zu haben.

Bevorzugt ist die Leiterplatte 1 als die mehrlagige Leiterplatte 1 aufgebaut, deren Leiterplattenlagen sich insgesamt über eine gesamte Fläche der Leiterplatte 1 erstrecken.

Alternativ bevorzugt ist die Leiterplatte als eine Verbindung aus einer ersten Leiterplatte und mindestens einer zweiten Leiterplatte aufgebaut, die miteinander mechanisch verbunden sind und die jeweils mindestens eine Kupferlage oder Kupferschicht aufweisen. Bevorzugt weist dabei die erste Leiterplatte die Haltekontaktanschlüsse und die Endkontakte und die zweite Leiterplatte mindestens einen Teil oder auch alle HF-Kontaktanschlüsse auf, wobei die HF-Kontaktanschlüsse bevorzugt die Sacklöcher oder die durchkontaktierten Bohrungen sind. Bevorzugt sind die erste und die zweite Leiterplatte dabei zusammengeklebt, zusammengeklemmt, verpresst oder zusammengeschraubt. Dabei kann beispielsweise der zweiten Leiterplatte im Wesentlichen die Funktion der HF-Koppelkapazitäten zukommen. Dies kann den Vorteil haben, dass die zweite Leiterplatte auch nach einer Montage der Federkontakte in der ersten Leiterplatte auf die erste Leiterplatte aufgebracht werden und darin dann das Kontaktmittel eingebracht werden kann.

Bevorzugt bildet die Steckverbindereinheit mit der Leiterplatte zusammen einen RJ45-Stecker oder eine RJ45-Steckerbuchse oder einen anderen HF-Steckverbinder-Stecker oder eine andere HF-Steckerbuchse.

Vorstellbar ist auch, dass in der Leiterplatte zudem ein oder mehrere zusätzliche Kompensationskondensatoren implementiert sein können, die beispielsweise eine jeweilige Rückflussdämpfung zwischen den Endkontakten bilden oder ein Übersprechen weiter dämpfen können.

Ein erfindungsgemäßes Verfahren zur HF-Kompensation an einer Leiterplatten-Steckverbindereinheit umfasst folgende Schritte:
a) Bereitstellen der Leiterplatte mit den Haltekontaktanschlüssen zu einer elektromechanisch festen Montage der Steckverbindereinheit darauf und mit den Endkontakten für ein Kabelanschluss daran;
b) Bereitstellen der Federkontakte für die Steckverbindereinheit , die jeweils den ersten Endabschnitt, den gegenüberliegenden zweiten Endabschnitt und den dazwischenliegenden Berührungskontaktabschnitt aufweisen, wobei der jeweilige Federkontakt so ausgebildet wird, dass der erste Endabschnitt mit der Leiterplatte elektrisch und mechanisch fest verbunden wird, wobei der Berührungskontaktabschnitt von der Leiterplatte in einer Steckrichtung und von der Leiterplatte weg mit dem nach außen abstehenden Höcker gebogen wird und dabei zur Leiterplatte hin elastisch ist, wobei der sich anschließende zweite Endabschnitt in der Steckrichtung und zur Leiterplatte hin zurückgebogen wird, um zusammen mit der Leiterplatte die Leiterplatten-Steckverbindereinheit zu bilden, die mit der entsprechenden Gegensteckverbindereinheit elektromechanisch verbindbar und davon lösbar ist;
c) Anordnen der HF-Kontaktanschlüsse in der Leiterplatte unter den zweiten Endabschnitten der Federkontakte und elektrisches Verbinden der HF-Kontaktanschlüsse über Kontaktmittel mit den zweiten Endabschnitten, wobei zwischen mindestens zwei der HF-Kontaktanschlüssen Koppelkapazitäten angeordnet werden, indem in der Leiterplatte entsprechende Kondensatorflächen in benachbarten Lagen übereinander angeordnet und mit den dazugehörigen HF-Kontaktanschlüssen verbunden werden oder indem in der Leiterplatte ein Kondensator angeordnet und mit den dazugehörigen HF-Kontaktanschlüssen verbunden wird, wobei die HF-Kontaktanschlüsse als metallisierte Sacklöcher oder metallisierte Durchgangsbohrungen ausgebildet sind, die mit dem jeweiligen zweiten Endabschnitt durch die jeweiligen Kontaktmittel elektrisch verbunden oder verbindbar sind, und
d) Eintauchen des jeweiligen zweiten Endabschnitts in das Sackloch oder die Durchgangsbohrung des dazugehörigen HF-Kontaktanschlusses durch das jeweilige Kontaktmittel.

Bei dem oben genannten Verfahren können die jeweiligen Elemente immer so ausgebildet werden wie zuvor bei der Leiterplatten-Steckverbinder-Einheit beschrieben.

Bei dem oben genannten Verfahren kann die Eintauchtiefe variabel sein.

Bevorzugte Ausführungsformen gemäß der vorliegenden Erfindung sind in nachfolgenden Zeichnungen und in einer detaillierten Beschreibung dargestellt, sie sollen aber die vorliegende Erfindung nicht ausschließlich darauf begrenzen.

Es zeigen
- Fig. 1: eine perspektivische Seitenansicht einer Steckverbindereinheit aus dem Stand der Technik mit elastischen Federkontakten, die jeweils einen ersten Endabschnitt, einen gegenüberliegenden zweiten Endabschnitt und einen dazwischenliegenden Berührungskontaktabschnitt aufweisen, wobei der jeweilige Federkontakt so ausgebildet ist, dass der erste Endabschnitt mit einer Leiterplatte elektrisch und mechanisch fest verbindbar ist, wonach der Berührungskontaktabschnitt ab einem Punkt von der Leiterplatte in einer Steckrichtung und von der Leiterplatte weg mit einem nach außen abstehenden Höcker gebogen und dabei elastisch ist, wobei der sich anschließende zweite Endabschnitt in der Steckrichtung und zur Leiterplatte hin zurückgebogen und an Enden mit einer flexiblen Leiterplatte verbunden ist;
- Fig. 2: eine perspektivische Seitenansicht einer bevorzugten Steckverbindereinheit gemäß der vorliegenden Erfindung mit elastischen Federkontakten, die jeweils den ersten Endabschnitt, den gegenüberliegenden zweiten Endabschnitt und den dazwischenliegenden Berührungskontaktabschnitt aufweisen, wobei die ersten Endabschnitte mit Haltekontaktanschlüssen der Leiterplatte elektrisch und mechanisch fest verbunden sind und die zweiten Endabschnitte zur Leiterplatte hin zurückgebogen sind und in Sacklöcher, die HF-Kontaktanschlüsse sind, eintauchen;

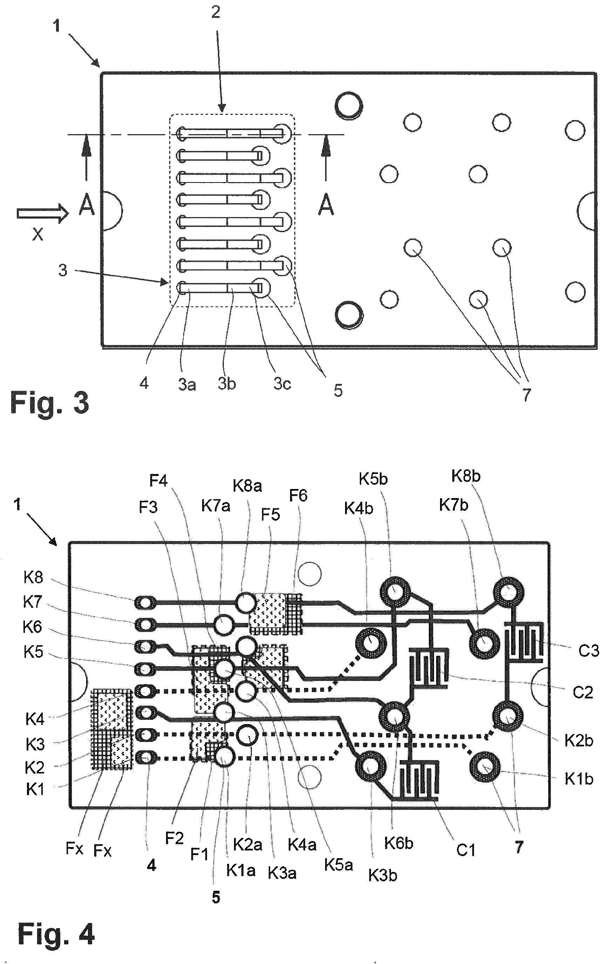

- Fig. 3: eine Ansicht von oben auf die bevorzugte Steckverbindereinheit gemäß Fig. 2 mit den elastischen Federkontakten über der Leiterplatte, den Haltekontaktanschlüssen und den HF- Kontaktanschlüssen;
- Fig. 4: eine Ansicht von oben auf die bevorzugte Steckverbindereinheit gemäß Fig. 3, jedoch ohne die Federkontakte und schematisch gezeichnet mit in der Leiterplatte enthaltenen Leitern und Kondensatorflächen und zusätzlichen Kondensatorflächen;

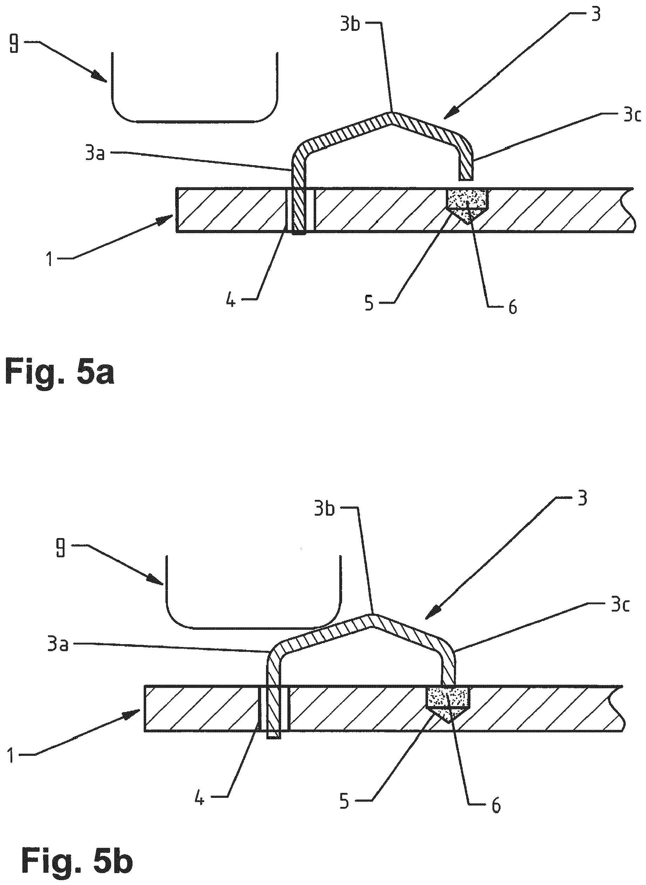

- Fig. 5a: eine Seitenansicht auf einen vergrößerten Ausschnitt der bevorzugten Steckverbindereinheit gemäß Fig. 2, die insbesondere den Federkontakt zeigt, der mit seinem ersten Endabschnitt in dem dazugehörigen Haltekontaktanschluss sitzt und mit seinem zweiten Endabschnitt zurück zur Leiterplatte gebogen über dem dazugehörigen Sackloch, das der HF-Kontaktanschluss ist, liegt;
- Fig. 5b: eine Seitenansicht auf einen vergrößerten Ausschnitt der bevorzugten Steckverbindereinheit gemäß Fig. 2, die insbesondere den Federkontakt zeigt, der mit seinem ersten Endabschnitt in dem dazugehörigen Haltekontaktanschluss sitzt und mit seinem zweiten Endabschnitt zurück zur Leiterplatte gebogen und in das dazugehörige Sackloch teilweise eingeführt ist, das der HF-Kontaktanschluss ist;

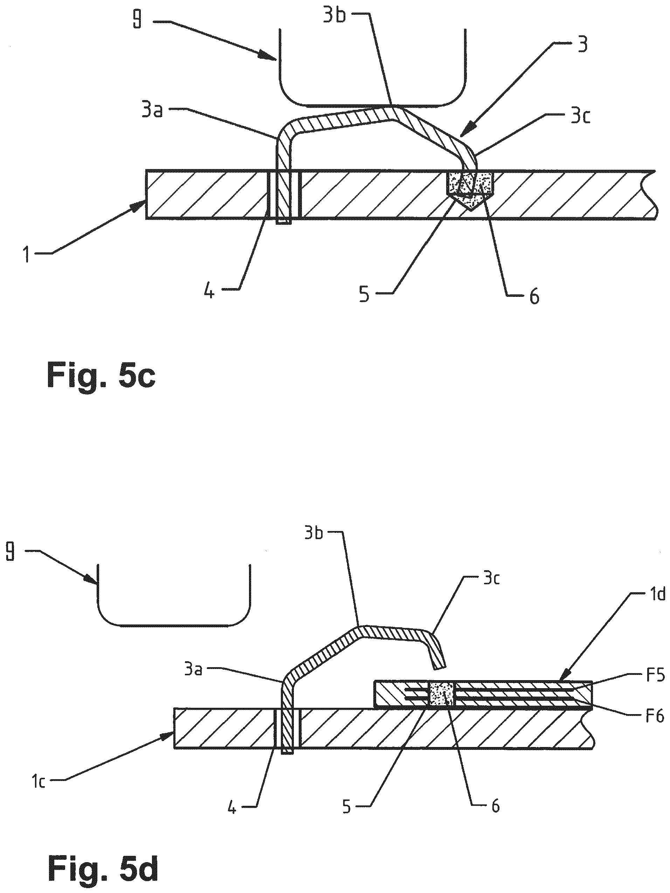

- Fig. 5c: eine Seitenansicht auf einen vergrößerten Ausschnitt der bevorzugten Steckverbindereinheit gemäß Fig. 2, die insbesondere den Federkontakt zeigt, der mit seinem ersten Endabschnitt in dem dazugehörigen Haltekontaktanschluss sitzt und mit seinem zweiten Endabschnitt zurück zur Leiterplatte gebogen und in das dazugehörige Sackloch vollständig eingeführt ist, das der HF-Kontaktanschluss ist;
- Fig. 5d: eine Seitenansicht auf einen vergrößerten Ausschnitt einer bevorzugten Steckverbindereinheit ähnlich wie in Fig. 2, wobei die Leiterplatte als eine Verbindung aus einer ersten Leiterplatte wie in Fig. 2 und einer zweiten Leiterplatte aufgebaut ist, die mit der ersten Leiterplatte mechanisch verbunden ist und den HF-Kontaktanschluss für den Federkontakt aufweist, wobei der zweite Endabschnitt zurück zur Leiterplatte gebogen über dem dazugehörigen Sackloch, das der HF-Kontaktanschluss ist, liegt;

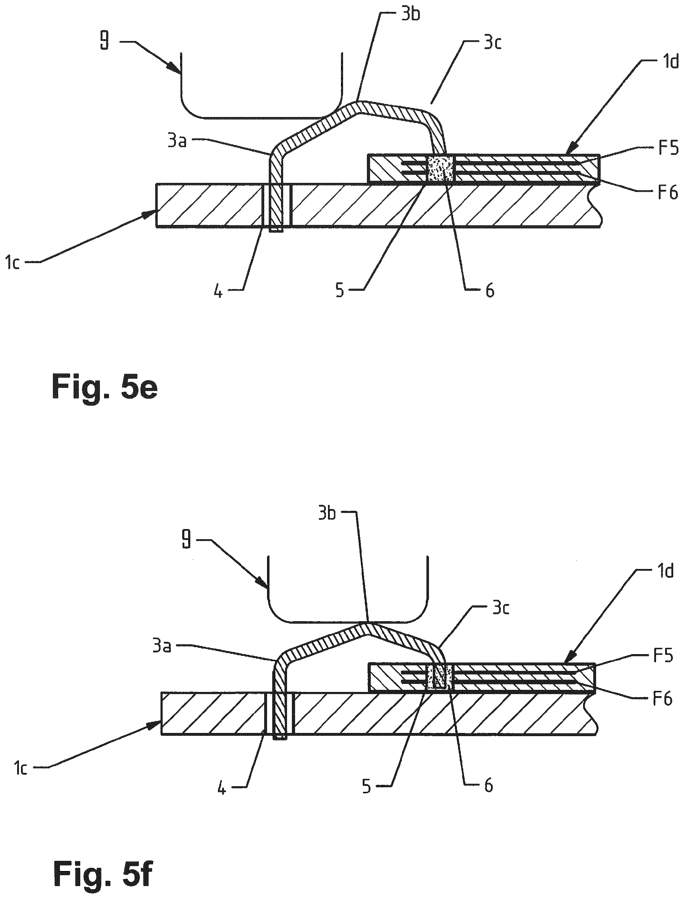

- Fig. 5e: eine Seitenansicht auf einen vergrößerten Ausschnitt einer bevorzugten Steckverbindereinheit ähnlich wie in Fig. 2, wobei die Leiterplatte als eine Verbindung aus einer ersten Leiterplatte wie in Fig. 2 und einer zweiten Leiterplatte aufgebaut ist, die mit der ersten Leiterplatte mechanisch verbunden ist und den HF-Kontaktanschluss für den Federkontakt aufweist, wobei der zweite Endabschnitt zurück zur Leiterplatte gebogen und in das dazugehörige Sackloch teilweise eingeführt ist, das der HF-Kontaktanschluss ist
- Fig. 5f: eine Seitenansicht auf einen vergrößerten Ausschnitt einer bevorzugten Steckverbindereinheit ähnlich wie in Fig. 2, wobei die Leiterplatte als eine Verbindung aus einer ersten Leiterplatte wie in Fig. 2 und einer zweiten Leiterplatte aufgebaut ist, die mit der ersten Leiterplatte mechanisch verbunden ist und den HF-Kontaktanschluss für den Federkontakt aufweist, wobei der zweite Endabschnitt zurück zur Leiterplatte gebogen und in das dazugehörige Sackloch vollständig eingeführt ist, das der HF-Kontaktanschluss ist; und

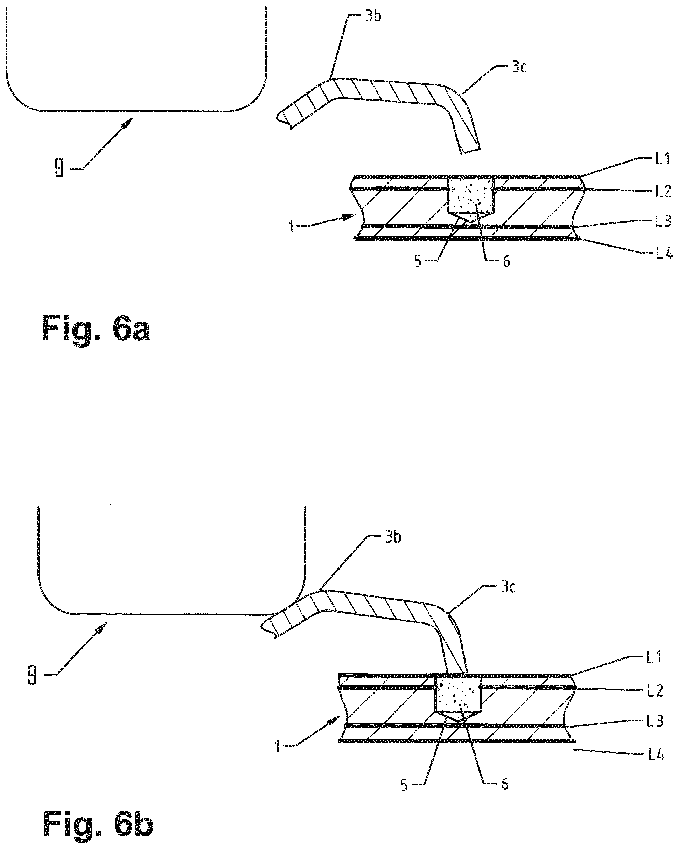

- Fig. 6a: eine Seitenansicht auf einen nochmals vergrößerten Ausschnitt der bevorzugten Steckverbindereinheit gemäß Fig. 5a, wobei die Leiterplatte als eine vierlagige Leiterplatte ausgebildet ist und das Sackloch mit einem Kontaktmittel gefüllt ist, das das Sackloch mit den zweiten Endabschnitt des Federkontakts elektrisch verbindet;
- Fig. 6b: eine Seitenansicht auf einen nochmals vergrößerten Ausschnitt der bevorzugten Steckverbindereinheit gemäß Fig. 5b, wobei die Leiterplatte als eine vierlagige Leiterplatte ausgebildet ist und das Sackloch mit einem Kontaktmittel gefüllt ist, das das Sackloch mit den zweiten Endabschnitt des Federkontakts elektrisch verbindet;

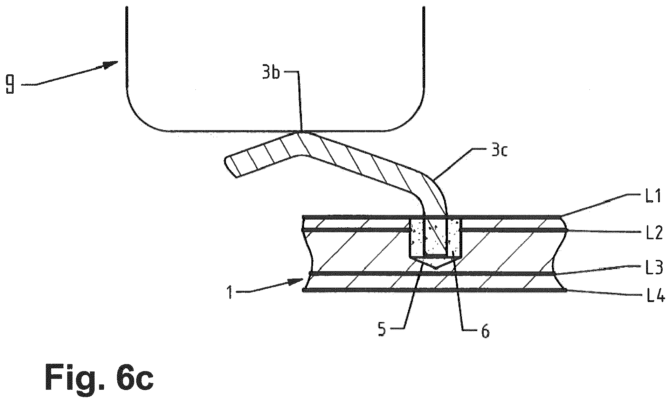

- Fig. 6c: eine Seitenansicht auf einen nochmals vergrößerten Ausschnitt der bevorzugten Steckverbindereinheit gemäß Fig. 5c, wobei die Leiterplatte als eine vierlagige Leiterplatte ausgebildet ist und das Sackloch mit einem Kontaktmittel gefüllt ist, das das Sackloch mit den zweiten Endabschnitt des Federkontakts elektrisch verbindet.

### Detaillierte Beschreibung verschiedener Ausführungsbeispiele

In Fig. 1 ist eine Steckverbindereinheit 2 mit Federkontakten 3 dargestellt, die zu einer Montage auf einer Leiterplatte 1 ausgelegt ist, um mit der Leiterplatte eine entsprechende Leiterplatten-Steckverbinder-Einheit gemäß dem Stand der Technik zu bilden. Die Federkontakte 3 sind elastisch und weisen jeweils einen ersten Endabschnitt 3a, einen gegenüberliegenden zweiten Endabschnitt 3c und einen dazwischenliegenden Berührungskontaktabschnitt 3b, der höckerartig ist, auf. Der jeweilige Federkontakt 3 ist so ausgebildet, dass der erste Endabschnitt 3a mit einer Leiterplatte 1 elektrisch und mechanisch fest verbunden wird, wonach der Berührungskontaktabschnitt 3b von der Leiterplatte 1, die nicht dargestellt ist, in einer Steckrichtung x mit einem nach außen abstehenden Höcker oder eine Erhöhung weggebogen ist. Der sich anschließende zweite Endabschnitt 3c ist in der Steckrichtung x und zur Leiterplatte 1 hin wieder etwas zurückgebogen, um keine Widerhakenfunktion nach einem Verbinden mit einem entsprechenden Gegenkontakt zu bilden. Die zurückgebogenen zweiten Endabschnitte 3c sind elektrisch und mechanisch mit einer flexiblen zusätzlichen Leiterplatte 8 verbunden, die Koppelkapazitäten zu einer HF-Kompensation umfasst.

Bekannt sind auch in einer Leiterplatten-Steckverbinder-Einheit integrierte HF-Koppelkapazitäten, die, wie in Fig. 4 dargestellt, als weitere Kondensatorflächen Fx in die jeweilige Leiterplatte 1 integriert sind, die über einen jeweiligen Haltekontaktanschluss 4 mit dem jeweiligen Federkontakt verbunden sind.

In Fig. 2 und Fig. 3 sind verschiedene Ansichten einer möglichen Ausbildung der Leiterplatten-Steckverbinder-Einheit mit integrierten HF-Koppelkapazitäten gemäß der vorliegenden Erfindung dargestellt, wobei die Leiterplatten-Steckverbinder-Einheit generell Folgendes aufweist:
a) eine Steckverbindereinheit 2 mit zwei oder mehr elastischen Federkontakten 3, die jeweils den ersten Endabschnitt 3a, den gegenüberliegenden zweiten Endabschnitt 3c und den dazwischenliegenden Berührungskontaktabschnitt 3b, der höckerartig ist, aufweisen. Dabei ist der jeweilige Federkontakt 3 so ausgebildet, dass der erste Endabschnitt 3a mit der Leiterplatte 1 elektrisch und mechanisch fest verbunden wird, wonach der Berührungskontaktabschnitt 3b von der Leiterplatte 1 in der Steckrichtung x und von der Leiterplatte 1 weg mit dem nach außen abstehenden Höcker gebogen ist. Bevorzugt ist der Federkontakt zur Leiterplatte 1 hin elastisch biegbar oder federnd. Der sich anschließende zweite Endabschnitt 3c ist in der Steckrichtung x und zur Leiterplatte 1 hin zurückgebogen und bildet so zusammen mit der Leiterplatte 1 die Leiterplatten-Steckverbindereinheit, die manuell mit einer dazu passenden Gegensteckverbindereinheit verbindbar und davon wieder lösbar ist;
b) die Leiterplatte 1, die in einem ersten Leiterplattenabschnitt 1a Haltekontaktanschlüsse 4 und in einem in Steckrichtung x gegenüberliegenden zweiten Leiterplattenabschnitt 1b Endkontakte 7 aufweist, wobei die ersten Endabschnitte 3a mit den Haltekontaktanschlüssen 4 elektromechanisch verbunden sind. Zur Klarheit bedeutet elektromechanisch an dieser Stelle, dass eine elektrische und eine mechanisch feste Verbindung vorliegt. Die Endkontakte 7 sind jeweils durch mindestens eine Leiterbahn mit dem jeweils dazugehörigen Haltekontaktanschluss 4 elektrisch verbunden;
Erfindungsgemäß sind/ist
c) in der Leiterplatte 1 unter den zweiten Endabschnitten 3c der Federkontakte 3 jeweilige HF-Kontaktanschlüsse 5 angeordnet, die über jeweilige Kontaktmittel 6 mit dem jeweiligen zweiten Endabschnitt 3c elektrisch verbunden sind, oder die Federkontakte 3 sind zu den jeweiligen HF-Kontaktanschlüssen 5 derart angeordnet, dass bei einer Einfederung der Federkontakte 3, die bei der Verbindung der Leiterplatten-Steckverbinder-Einheit mit der Gegensteckverbindereinheit erfolgt, eine Kontaktierung der jeweiligen Endabschnitte 3c mit den jeweiligen HF-Kontaktanschlüssen 5 über die jeweiligen Kontaktmittel 6 entsteht; und
d) in der Leiterplatte 1, die mehrere Lagen aufweist, sind mindestens zwei der HF-Kontaktanschlüsse 5 jeweils mit einer Kondensatorfläche F1-F6 verbunden, die in übereinanderliegenden Lagen zumindest teilweise überlappend angeordnet sind, um die jeweilige entsprechende HF-Koppelkapazität zu einer HF-Kompensation zwischen den damit verbundenen Federkontakten 3 zu bilden,
e) die HF-Kontaktanschlüsse 5 als metallisierte Sacklöcher oder metallisierte Durchgangsbohrungen ausgebildet, die mit dem jeweiligen zweiten Endabschnitt 3c durch die jeweiligen Kontaktmittel 6 elektrisch verbunden oder verbindbar sind, und
f) der jeweilige zweite Endabschnitt 3c in das Sackloch oder die Durchgangsbohrung des dazugehörigen HF-Kontaktanschlusses 5 in das jeweilige Kontaktmittel 6 eintauchbar.

Alternativ dazu kann die HF-Koppelkapazität als Kondensator nach dem Funktionsprinzip der Nutzung inkrementeller Kapazität ausgebildet werden und in dieser alternativen Ausführungsform kann die Leiterplatte einlagig aufgebaut sein. In dieser nicht dargestellten Alternative weist die Leiterplatte 1 mindestens zwei der HF-Kontaktanschlüsse 5 auf, die jeweils mit dem Kondensator verbunden sind, um die jeweilige entsprechende HF-Koppelkapazität zu einer HF-Kompensation zwischen den damit verbundenen Federkontakten 3 zu bilden.

Das Kontaktmittel 6 ist in den Figuren 5a bis 6c zu erkennen, in den Fig. 2-4 ist das Kontaktmittel 6 nicht dargestellt. Als Kontaktmittel 6 kann beispielsweise vorteilhaft eine elastische Leitpaste eingesetzt werden, insbesondere eine elektrisch leitfähige Silikonpaste. Als besonders vorteilhaft hat sich eine elektrisch leitfähige Silikonpaste mit HF-dämpfenden Eigenschaften erwiesen, wie etwa eine, die unter dem Handelsnamen NEUSIL^{™} K682 von der Firma Neuhaus Elektronik GmbH aus Berlin vertrieben wird.

In Fig. 2 ist strichliert noch ein Halter oder Führungsteil angedeutet, das bevorzugt vorhanden sein kann, um die Federkontakte 3 besser in einer vorbestimmten Position zu halten und/oder zu führen, wie oben beschrieben.Vergrößerte Teilschnittansichten der Leiterplatten-Steckverbinder-Einheit sind in den Figuren 5a bis 5f dargestellt, die zeigen, wie der Federkontakt 3 gebogen sein kann und in der Leiterplatte 1 sitzen kann. Ein nochmals vergrößerter Ausschnitt des Berührungskontaktabschnitts 3b mit dem Höcker und des zweiten Endabschnitts 3c mit dem damit elektrisch verbundenen Kontaktmittel 6 ist in den Figure 6b bis 6c dargestellt. Fig. 6a zeigt den nicht verbundenen Zustand. Der jeweilige HF-Kontaktanschluss 5 kann dabei als Sackloch, wie in den Figuren 5a bis 6c dargestellt, oder auch als Durchgangsbohrung oder als Loch mit Durchgangskontaktierung ausgebildet sein. Bevorzugt ist der Federkontakt 3 mit dem dazugehörigen HF-Kontaktanschluss 5 über das Kontaktmittel 6 dauerhaft elektrisch verbunden, indem der Federkontakt 3 immer im Kontaktmittel 6 eingetaucht ist.

Nach einem weiteren Aspekt der Erfindung können der Federkontakt 3 und die Anordnung zum dazugehörigen HF-Kontaktanschluss 5 so ausgebildet sein, dass bei einer Einfederung des Federkontakts 3, die bei der Verbindung der Leiterplatten-Steckverbinder-Einheit mit der Gegensteckverbindereinheit entsteht, erst dann eine Kontaktierung des Federkontakts 3 mit dem dazugehörigen HF-Kontaktanschluss 5 entsteht. Besagte Einfederung des Federkontakts 3 ist beispielhaft anhand der jeweils korrespondierenden Figuren 5a bis 5c, beziehungsweise 5d bis 5f sowie 6a bis 6c dargestellt, und zwar durch eine Gegensteckverbindereinheit 9, die beim Einsteckvorgang in die Leiterplatten-Steckverbinder-Einheit in Steckichtung X betätigt wird. Die Figuren 5b bis 5c und 5e bis 5f zeigen dabei jeweils den eingefederten Zustand, in welchem eine Kontaktierung des Federkontakts 3 mit dem dazugehörigen HF-Kontaktanschluss 5 vorliegt. Gleiches gilt für die Figuren 6b bis 6c.

Es sei an dierser Stelle angemerkt, dass die Figuren 5a bis 6c Ausführungsformen zeigen, in denen die Federkontakte 3 im nicht eigesteckten Zustand der Leiterplatten-Steckverbinder-Einheit vom Kontaktmittel 6 beabstandet sind, so dass die elektrische Verbindung mit den Kontaktmitteln 6 erst mit dem Einsteckvorgang der Leiterplatten-Steckverbinder-Einheit realisiert wird. Bei weiteren nicht dargestellten Ausführungsformen, sind die Federkontakte bereits vor dem Einsteckvorgang im Kontaktmittel 6 eingetaucht.

In allen Ausführungsformen ändert sich jedoch die Eintauchtiefe der Federkontakte 3, insbesondere des zweiten Endabschnitts 3c, in das Kontaktmittel 6. Die Änderung der Eintauchtiefe erfolgt beim Einsteckvorgang aufgrund der Ausgestaltung der Federkontakte 3 und der Elastizität dieser. Somit kann die HF-Kompensation verbessert werden, indem Asymmetrien der Leiterplatten-Steckverbinder-Einheit ausgeglichen werden. Darüber hinaus werden Spannungen in den Federkontakten, die nach dem Einsteckvorgang entstehen, vermieden und die Anzahl der Einsteckvorgänge wird erhöht.

In Fig. 4 ist die Leiterplatte 1 als ein Ausbildungsbeispiel dargestellt. Dabei sind die Haltekontaktanschlüsse 4, indiziert durch einen ersten K1 bis zu einem achten Anfangskontakt K8, über entsprechende Leiterbahnen mit den Endkontakten 7 verbunden, die indiziert sind durch einen ersten Endkontakt K1b bis zu einem achten Endkontakt K8b. Die Leiterbahnen sind dabei als Striche oder strichliert dargestellt. Die dazwischenliegenden HF-Kontaktanschlüsse 5 sind indiziert durch einen ersten K1a bis zu einem achten HF-Kompensationskontakt K8a. Im dargestellten Beispiel ist der erste HF-Kompensationskontakt K1a mit einer ersten Kondensatorfläche F1 verbunden, die kariert dargestellt ist. Der dritte HF-Kompensationskontakt K3a ist mit einer zweiten Kondensatorfläche F2 verbunden, die punktiert dargestellt ist und mit der ersten Kondensatorfläche F1 eine erste HF-Koppelkapazität bildet. Der dritte HF-Kompensationskontakt K3a ist zudem mit einer dritten Kondensatorfläche F3 verbunden, die punktiert dargestellt ist. Der fünfte HF-Kompensationskontakt K5a ist mit einer vierten Kondensatorfläche F4 verbunden, die kariert dargestellt ist und mit der dritten Kondensatorfläche F3 eine zweite HF-Koppelkapazität bildet. Der siebte HF-Kompensationskontakt K7a ist mit einer sechsten Kondensatorfläche F6 verbunden, die kariert dargestellt ist. Der achte HF-Kompensationskontakt K8a ist mit einer fünften Kondensatorfläche F5 verbunden, die punktiert dargestellt ist und mit der sechsten Kondensatorfläche F6 eine dritte HF-Koppelkapazität bildet. Bevorzugt sind die Kondensatorflächen F1-F6 jeweils möglichst nahe an dem dazugehörigen HF-Kontaktanschluss angeordnet. Denkbar ist auch eine Anordnung zusätzlicher weiterer Kondensatorflächen Fx, wie links in Fig. 4 dargestellt. Denkbar ist auch eine Anordnung zusätzlicher Kompensationskondensatoren C1 - C3, die zwischen und bevorzugt nahe den Endkontakten 7 angeordnet sind. Beispielsweise ist ein erster zusätzlicher Kompensationskondensator C1 in Fig. 4 zwischen dem dritten K3b und dem sechsten Endkontakt K6b angeordnet. Die zusätzlichen Kompensationskondensatoren C1-C3 erzeugen eine Rückflussdämpfung zwischen den entsprechenden Endkontakten 7 und/oder zwischen daran angeschlossenen Schneidklemmen. Ebenso vorstellbar sind auch zusätzliche Kondensatoren, die als Chip-Kondensatoren in oder auf der Leiterplatte 1 angeordnet sind und/oder mit den Haltekontaktanschlüssen 4 und/oder mit den HF-Kontaktanschlüssen 5 und/oder mit den Endkontakten 7 elektrisch verbunden sind.

Bevorzugt ist die Leiterplatte 1 mit zwei oder mehr Kupferlagen aufgebaut, so dass die Leiterbahnen und die Kondensatorflächen F1-F6 in bekannter Weise übereinander angeordnet werden können, um dabei mehr oder weniger Koppelkapazität zwischen den Leitern und zwischen den Kondensatorflächen F1-F6 zu erzeugen. In den Figuren 6a bis 6c ist die Leiterplatte 1 als eine vierlagige Leiterplatte 1 mit einer ersten L1 bis vierten Lage L4 dargestellt. Zur Klarheit können die Lagen auch als Schichten bezeichnet werden. Es versteht sich, dass die Löcher oder Sacklöcher zu einer elektrischen Kontaktvermittlung metallisiert sein können, wie üblich.

In den Figuren 5d bis 5f ist jeweils ein vergrößerter Ausschnitt einer bevorzugten Ausbildung der Leiterplatte 1 dargestellt, worin die Leiterplatte 1 zweiteilig ausgebildet ist. Die zweiteilige Leiterplatte umfasst mindestens eine erste Leiterplatte 1c und eine zweite Leiterplatte 1d, die zueinander angrenzend angeordnet sind. Vorzugsweise sind die erste und zweite Leiterplatte 1c, 1d miteinander mechanisch verbunden. Bevorzugt sind die erste und die zweite Leiterplatte 1c, 1d dabei zusammengeklebt, zusammengeklemmt, verpresst oder zusammengeschraubt. Dabei weist die erste Leiterplatte 1c bevorzugt die Haltekontaktanschlüsse 4 und die Endkontakte 7 mit mindestens einer Kupferlage zu einer Verbindung zwischen den Haltekontaktanschlüssen 4 und den zugehörigen Endkontakten 7 auf. Wie in den Figuren 5d bis 5f dargestellt, umfasst vorzugsweise die zweite Leiterplatte 1d die HF-Kontaktanschlüsse 5, die beispielsweise als metallisierte Bohrungen ausgebildet sind, und mindestens zwei Kupferlagen, die als die Kondensatorflächen F5-F6 ausgebildet und mit den dazugehörigen HF-Kontaktanschlüssen 5 elektrisch verbunden (nicht dargestellt) oder durch Einfederung des Federkontakts 3 verbindbar, wie dargestellt, sind. Es ist denkbar, dass in einer weiteren bevorzugten Ausführungsform die Kondensatorflächen F1 bis F6 von Kupferlagen gebildet werden, die sich nur in der zweiten Leiterplatte 1d befinden. Alternativ können die Kondensatorflächen F1 bis F6 von Kupferlagen gebildet werden, die sich nur in der ersten Leiterplatte 1c befinden. In einer weiteren Alternative können die Kondensatorflächen F1 bis F6 von Kupferlagen gebildet werden, die sich sowohl in der ersten Leiterplatte 1c als auch in der zweiten Leiterplatte 1d befinden. Abhängig von der Zugehörigkeit der Kupferlagen zu einer der beiden Leiterplatten 1c und 1d müssen die HF-Kontaktanschlüsse 5 angepasst werden. Bevorzugt können die HF-Kontaktanschlüsse 5 sowohl in der ersten 1c als auch in der zweiten Leiterplatte 1d ausgebildet sein, wenn demgemäß die Kondensatorflächen sich zumindest teilweise sowohl in der ersten 1c als auch in der zweiten Leiterplatte 1d befinden.

Vorteilhaft an einem Leiterplattenverbund aus der ersten 1c und der zweiten Leiterplatte 1d ist, dass die zweite Leiterplatte 1d noch näher an dem jeweiligen Berührungskontaktabschnitt 3b angeordnet sein kann (siehe Figuren 5d bis 5f), wodurch sich durch die Nähe eine nochmals verbesserte HF-Kompensation ergibt. Besonders vorteilhaft ist in dieser Ausbildungsform, wenn alle Kondensatorflächen F1 bis F6 von Kupferlagen gebildet werden, die sich nur in der zweiten Leiterplatte 1d befinden.

Weiterhin ist in einer von den Figuren 5d bis f abweichenden Ausbildung denkbar, dass die Leiterplatte 1 aus einem Verbund von drei oder mehr Leiterplatten gebildet wird, wobei die Kondensatorflächen entsprechend verteilt sein können.

An den Endkontakten 7 der Leiterplatte 1 können bekannterweise beispielsweise Schneidklemmen angeschlossen oder direkt Kabel angelötet werden, es ist aber auch denkbar, dass die Endkontakte 7 direkt mit einer Elektronik auf der Leiterplatte 1 elektrisch verbunden sind.

Die vorstehend geschilderte Erfindung ist insofern vorteilhaft, da eine Anordnung zur Verfügung gestellt wird, die konstruktive Asymmetrien im Aufbau von Steckern kompensiert. Insbesondere können Stecker, wie etwa RJ45 Stecker, Asymmetrien aufgrund der unterschiedlichen Krimptiefe aufweisen, die von der einschlägigen Norm, nämlich der IEC 60603 zugelassen werden. Die variable Eintauchbarkeit der Endabschnitte 3c der Federkontakte 3 in die jeweiligen HF-Kontaktanschlüsse 5 bzw. in die jeweiligen Kontaktmittel 6 gestattet eine gleichbleibende HF-Kopplung trotz Asymmetrien der Stecker, die insbesondere bei hohen Übertragungsfrequenzen bis 2 GHz wie in KAT 8 Bereich üblich, besonders vorteilhaft ist. Die variable Eintauchbarkeit der Endabschnitte 3c der Federkontakte 3 in die jeweiligen HF-Kontaktanschlüsse 5 bzw. in die jeweiligen Kontaktmittel 6 gestattet gleichzeitig, dass die Strecke zu den HF-Koppelkapazitäten verkürzt wird, was wiederum bei hohen Frequenzen vorteilhaft ist.

Zur Klarheit bedeutet Steckrichtung die Richtung, in der die Leiterplatten-Steckverbinder-Einheit und die Gegensteckverbindereinheit ineinandergesteckt werden.

Zur Klarheit bedeutet mechanisch fest verbunden zu sein eine Verbindung, bei der sich die ersten Endabschnitte 3a in den Haltekontaktanschlüssen der Leiterplatte 1 bei einer Belastung der Federkontakte 3 beim Einstecken in die Gegensteckverbindereinheit in der Leiterplatte nicht verschieben. Bevorzugt ist eine solche mechanisch feste Verbindung eine Klemm- oder Schraub- oder Lötverbindung.

Zur Klarheit bedeutet "in der Leiterplatte", dass sich beispielsweise die Kondensatorflächen sowohl auf als auch innerhalb der mehrlagigen Leiterplatte 1 befinden können.

Zur Klarheit wird unter den mehreren Lagen der Leiterplatte verstanden, dass die Leiterplatte mehrere Kupferlagen oder sonstige leitfähige Lagen umfasst. Bevorzugt umfasst die Leiterplatte vier Lagen, die auch Kupferlagen genannt werden können.

Zur Klarheit ist die Formulierung "die HF-Kontaktanschlüsse 5 sind jeweils über die jeweiligen Kontaktmittel 6 mit dem jeweiligen zweiten Endabschnitt 3c elektrisch verbunden" so zu verstehen, dass zumindest zwei der zweiten Endabschnitte 3c mit dazugehörigen HF-Kontaktanschlüssen 5 elektrisch verbunden sind.

Zur Klarheit sind unter den Merkmalen "oben" und "unten" relative Ortsangaben in senkrechter Richtung zu verstehen, so wie in den Figuren dargestellt.

Zur Klarheit sei auch angemerkt, dass unbestimmte Artikel in Verbindung mit einem Gegenstand oder Zahlenangaben, wie beispielsweise "ein" Gegenstand, den Gegenstand nicht zahlenmäßig auf genau einen Gegenstand begrenzen, sondern dass mindestens "ein" Gegenstand damit gemeint ist. Dies gilt für alle unbestimmten Artikel wie beispielsweise "ein", "eine" usw.

Es versteht sich, dass, wenn ein Element als "auf" einem anderen Element angebracht, damit "verbunden", "gekoppelt" oder "in Kontakt" damit bezeichnet wird, das Element sich dann direkt auf dem anderen Element befinden, damit verbunden oder gekoppelt sein kann, oder dass außerdem dazwischenliegende Elemente vorhanden sein können, die entweder nur dazwischenliegen oder das Element mit dem anderen Element verbinden oder koppeln oder in Kontakt halten. Wenn hingegen ein Element als "direkt auf" einem anderen Element, damit "direkt verbunden", "direkt gekoppelt" oder "direkt in Kontakt" bezeichnet wird, ist dies dahingehend zu verstehen, dass keine dazwischenliegenden Elemente vorhanden sind. In ähnlicher Weise ist, wenn ein erstes Element als "in elektrischem Kontakt mit einem zweiten Element" oder damit "elektrisch gekoppelt" bezeichnet wird, eine elektrische Bahn vorhanden, die den Stromfluss zwischen dem ersten Element und dem zweiten Element ermöglicht. Die elektrische Bahn kann Kondensatoren, gekoppelte Induktivitäten und/oder andere Elemente einschließen, die auch ohne direkten Kontakt zwischen den leitenden Elementen einen Stromfluss ermöglichen.

Obwohl die Ausdrücke "erstes", "zweites" usw. hierin verwendet werden können, um verschiedene Elemente, Komponenten, Bereiche und/oder Abschnitte zu bezeichnen, sind diese Elemente, Komponenten, Bereiche und/oder Abschnitte nicht durch diese Ausdrücke beschränkt. Die Ausdrücke werden nur verwendet, um ein Element, eine Komponente, einen Bereich oder Abschnitt von einem anderen Element, einer anderen Komponente, einem anderen Bereich oder Abschnitt zu unterscheiden. Daher kann ein erstes Element, eine erste Komponente, ein erster Bereich oder Abschnitt, die unten behandelt sind, als zweites Element, zweite Komponente, zweiter Bereich oder Abschnitt bezeichnet werden, ohne von den Lehren der vorliegenden Erfindung abzuweichen.

Ausführungsformen der Erfindung sind hierin mit Bezug auf Querschnittsansichten beschrieben, die schematische Darstellungen von Ausführungsformen der Erfindung sind. Daher kann sich die tatsächliche Dicke der Komponenten davon unterscheiden, und Abweichungen von den Formen in den Darstellungen, zum Beispiel aufgrund von Herstellungsverfahren und/oder Toleranzen, sind zu erwarten. Ausführungsformen der Erfindung sind nicht als auf die speziellen Formen der hierin dargestellten Bereiche beschränkt zu verstehen, sondern sollen Abweichungen der Formen einschließen, die zum Beispiel aus der Art der Herstellung resultieren. Ein Bereich, der als quadratisch oder rechteckig dargestellt oder bezeichnet ist, hat typischerweise auch gerundete oder gekrümmte Merkmale aufgrund normaler Herstellungstoleranzen. Daher sind die in den Figuren dargestellten Bereiche schematischer Art, und ihre Formen dienen nicht dazu, die genaue Form eines Bereichs einer Vorrichtung darzustellen oder den Schutzumfang der Erfindung zu beschränken.

Relationsausdrücke, wie zum Beispiel "inneres", "äußeres", "oberes", "über", "unter" und "unterhalb" und ähnliche Ausdrücke können verwendet werden, um eine Beziehung einer Lage oder eines anderen Bereichs zu einer anderen Lage oder einem anderen Bereich zu bezeichnen. Es versteht sich, dass diese Ausdrücke verschiedene Ausrichtungen der Vorrichtung zusätzlich zu der Ausrichtung umfassen sollen, die in den Figuren dargestellt ist.

Zum Ausdruck "umfassen" sei zur Klarheit gesagt, dass, wenn ein erster Vorrichtungsteil einen zweiten Vorrichtungsteil umfasst, dies bedeutet, dass der erste Vorrichtungsteil den zweiten Vorrichtungsteil "aufweist" und nicht notwendigerweise anordnungsmäßig umschließt, wenn es sich nicht beispielsweise um eine Beschreibung einer lagemäßigen und formenmäßigen Anordnung handelt; das Gleiche gilt für ein Verfahren, das einen oder mehrere Verfahrensschritte umfassen kann.

Weitere mögliche Ausbildungsformen sind in den folgenden Ansprüchen beschrieben. Insbesondere können auch die verschiedenen Merkmale der oben beschriebenen Ausführungsformen miteinander kombiniert werden, soweit sie sich nicht technisch ausschließen.

Die in den Ansprüchen genannten Bezugszeichen dienen nur der besseren Verständlichkeit und beschränken die Ansprüche in keiner Weise auf die in den Figuren dargestellten Formen.

### Bezugszeichenliste

- 1: Leiterplatte
- 1a: erster Leiterplattenabschnitt
- 1b: zweiter Leiterplattenabschnitt
- 1c: erste Leiterplatte
- 1d: zweite Leiterplatte
- 2: Steckverbindereinheit, bevorzugt Federsteckverbindereinheit
- 3: Federkontakt
- 3a: erster Endabschnitt
- 3b: Berührungskontaktabschnitt
- 3c: zweiter Endabschnitt
- 4: Haltekontaktanschlüsse, bevorzugt Haltekontaktlöcher
- 5: HF-Kontaktanschlüsse, bevorzugt HF-Kontaktlöcher
- 6: Kontaktmittel, bevorzugt Leitpaste
- 7: Endkontakte
- 8: zusätzliche Leiterplatte zur Kapazitätskompensation
- 9: Gegensteckverbindereinheit
- A-A: Ausschnitt A-A
- C1 - C3: erster - dritter zusätzlicher Kompensationskondensator
- F1 - F6: erste - fünfte Kondensatorfläche
- Fx: weitere Kondensatorflächen
- L1 - L6: erste - vierte Lage
- K1 - K8: erster - achter Anfangskontakt
- K1a - K8a: erster - achter HF-Kompensationskontakt
- K1b - K8b: erster - achter Endkontakt
- X: Steckrichtung

## Patentansprüche

1. Leiterplatten-Steckverbinder-Einheit mit integrierten HF-Koppelkapazitäten, die Folgendes umfasst:
a) eine Steckverbindereinheit (2) mit mindestens zwei elastischen Federkontakten (3), die jeweils einen ersten Endabschnitt (3a), einen gegenüberliegenden zweiten Endabschnitt (3c) und einen dazwischenliegenden Berührungskontaktabschnitt (3b) aufweisen, wobei der jeweilige Federkontakt (3) so ausgebildet ist, dass der erste Endabschnitt (3a) mit einer Leiterplatte (1) elektrisch und mechanisch fest verbunden ist, wonach der Berührungskontaktabschnitt (3b) von der Leiterplatte (1) in einer Steckrichtung (x) und von der Leiterplatte (1) weg mit einem nach außen abstehenden Höcker gebogen und dabei elastisch ist, wobei der sich anschließende zweite Endabschnitt (3c) in der Steckrichtung (x) und zur Leiterplatte (1) hin zurückgebogen ist, um so zusammen mit der Leiterplatte (1) die Leiterplatten-Steckverbindereinheit zu bilden, die manuell mit einer dazu passenden Gegensteckverbindereinheit verbindbar und davon wieder lösbar ist;
b) die Leiterplatte (1) mit Haltekontaktanschlüssen (4), die in einem ersten Leiterplattenabschnitt (1a) angeordnet und mit den jeweiligen ersten Endabschnitten (3a) der Federkontakte (3) elektromechanisch verbunden sind, wobei Endkontakte (7) in einem in der Steckrichtung (x) gegenüberliegenden zweiten Leiterplattenabschnitt (1b) angeordnet und durch mindestens eine Leiterbahn mit den dazugehörigen Haltekontaktanschlüssen (4) elektrisch verbunden sind;
c) wobei (i) in der Leiterplatte (1) unter den zweiten Endabschnitten (3c) der Federkontakte (3) jeweilige HF-Kontaktanschlüsse (5) angeordnet sind, die über jeweilige Kontaktmittel (6) mit dem jeweiligen zweiten Endabschnitt (3c) elektrisch verbunden sind, oder wobei (ii) die Federkontakte (3) zu den jeweiligen HF-Kontaktanschlussen (5) derart angeordnet sind, dass bei einer Einfederung der Federkontakte (3), die bei der Verbindung der Leiterplatten-Steckverbinder-Einheit mit der Gegensteckverbindereinheit erfolgt, eine Kontaktierung der jeweiligen Endabschnitte (3c) mit den jeweiligen HF-Kontaktanschlüssen (5) über die jeweiligen Kontaktmittel (6) entsteht;
d) wobei (i) in der Leiterplatte (1), die mehrere Lagen aufweist, mindestens zwei der HF-Kontaktanschlüsse (5) jeweils mit einer Kondensatorfläche (F1-F6) verbunden sind, die in übereinanderliegenden Lagen zumindest teilweise überlappend angeordnet sind, um die jeweilige entsprechende HF-Koppelkapazität zu einer HF-Kompensation zwischen den damit verbundenen Federkontakten (3) zu bilden, oder wobei (ii) in der Leiterplatte (1) mindestens zwei der HF-Kontaktanschlüsse (5) jeweils mit einem Kondensator verbunden sind, um die jeweilige entsprechende HF-Koppelkapazität zu einer HF-Kompensation zwischen den damit verbundenen Federkontakten (3) zu bilden,
e) wobei die HF-Kontaktanschlüsse (5) als metallisierte Sacklöcher oder metallisierte Durchgangsbohrungen ausgebildet sind, die mit dem jeweiligen zweiten Endabschnitt (3c) durch die jeweiligen Kontaktmittel (6) elektrisch verbunden oder verbindbar sind, und
f) wobei der jeweilige zweite Endabschnitt (3c) in das Sackloch oder die Durchgangsbohrung des dazugehörigen HF-Kontaktanschlusses (5) in das jeweilige Kontaktmittel (6) eintauchbar ist.

2. Die Leiterplatten-Steckverbinder-Einheit gemäß Anspruch 1, wobei der jeweilige Federkontakt (3) in der Steckrichtung (x) so gebogen ist, dass eine erste Länge des Federkontakts (3), die zwischen dem Haltekontaktanschluss (4) und dem Höcker bestimmt ist, größer ist als eine zweite Länge des Federkontakts (3), die zwischen dem Höcker und dem HF-Kontaktanschluss (5) bestimmt ist.

3. Die Leiterplatten-Steckverbinder-Einheit gemäß einem oder mehreren der vorstehenden Ansprüche, wobei der jeweilige zweite Endabschnitt (3c) mit dem dazugehörigen HF-Kontaktanschluss (5) gegen diesen mechanisch verschiebbar verbunden ist, so dass der zweite Endabschnitt (3c) in Richtung zum HF-Kontaktanschluss (5) in verschiedene Tiefen eintauchbar ist.

4. Die Leiterplatten-Steckverbinder-Einheit gemäß einem oder mehreren der vorstehenden Ansprüche, wobei das Kontaktmittel (6) eine Leitpaste oder eine HF-Leitpaste ist, wobei vorzugsweise die Leitpaste eine elektrisch leitfähige Silikonpaste ist, die insbesondere HF-dämpfende Eigenschaften hat.

5. Die Leiterplatten-Steckverbinder-Einheit gemäß einem oder mehreren der vorstehenden Ansprüche, wobei die Leiterplatte (1) als eine Verbindung aus einer ersten Leiterplatte (1c) und mindestens einer zweiten Leiterplatte (1d) aufgebaut ist, die miteinander mechanisch verbunden sind und die jeweils mindestens eine Kupferlage aufweisen, wobei die erste Leiterplatte (1c) die Haltekontaktanschlüsse (4) und die Endkontakte (7) und die zweite Leiterplatte (1d) mindestens einen der HF-Kontaktanschlüsse (5) aufweist.

6. Die Leiterplatten-Steckverbinder-Einheit gemäß einem oder mehreren der vorstehenden Ansprüche, wobei die Steckverbindereinheit (2) mit der Leiterplatte (1) zusammen einen HF-Steckverbinder-Stecker oder eine HF-Steckerbuchse bildet.

7. Die Leiterplatten-Steckverbinder-Einheit gemäß einem oder mehreren der vorstehenden Ansprüche, wobei die Steckverbindereinheit (2) mit der Leiterplatte (1) zusammen einen RJ45-Stecker oder eine RJ45-Steckerbuchse bildet.

8. Verfahren zur HF-Kompensation an einer Leiterplatten-Steckverbindereinheit, das folgende Schritte umfasst:
a) Bereitstellen einer Leiterplatte (1) mit Haltekontaktanschlüssen (4) zu einer elektromechanisch festen Montage einer Steckverbindereinheit (2) darauf und mit Endkontakten (7) für einen Kabelanschluss daran;
b) Bereitstellen von Federkontakten (3) für eine Steckverbindereinheit (2), die jeweils einen ersten Endabschnitt (3a), einen gegenüberliegenden zweiten Endabschnitt (3c) und einen dazwischenliegenden Berührungskontaktabschnitt (3b) aufweisen, wobei der jeweilige Federkontakt (3) so ausgebildet wird, dass der erste Endabschnitt (3a) mit der Leiterplatte (1) elektrisch und mechanisch fest verbunden wird, wobei der Berührungskontaktabschnitt (3b) von der Leiterplatte (1) in einer Steckrichtung (x) und von der Leiterplatte (1) weg mit einem nach außen abstehenden Höcker gebogen wird und dabei zur Leiterplatte (1) hin elastisch ist, wobei der sich anschließende zweite Endabschnitt (3c) in der Steckrichtung (x) und zur Leiterplatte (1) hin zurückgebogen wird, um zusammen mit der Leiterplatte (1) die Leiterplatten-Steckverbindereinheit zu bilden, die mit einer entsprechenden Gegensteckverbindereinheit elektromechanisch verbindbar und davon lösbar ist;
c) Anordnen von HF-Kontaktanschlüssen (5) in der Leiterplatte (1) unter den zweiten Endabschnitten (3c) der Federkontakte (3) und elektrisches Verbinden der HF-Kontaktanschlüsse (5) über Kontaktmittel (6) mit den zweiten Endabschnitten (3c), wobei zwischen mindestens zwei der HF-Kontaktanschlüsse (5) Koppelkapazitäten angeordnet werden, indem in der Leiterplatte (1) entsprechende Kondensatorflächen (F1-F6) in benachbarten Lagen übereinander angeordnet und mit den dazugehörigen HF-Kontaktanschlüssen (5) verbunden werden oder indem in der Leiterplatte (1) ein Kondensator angeordnet und mit den dazugehörigen HF-Kontaktanschlüssen (5) verbunden wird, wobei die HF-Kontaktanschlüsse (5) als metallisierte Sacklöcher oder metallisierte Durchgangsbohrungen ausgebildet sind, die mit dem jeweiligen zweiten Endabschnitt (3c) durch die jeweiligen Kontaktmittel (6) elektrisch verbunden oder verbindbar sind, und
d) Eintauchen der jeweiligen zweiten Endabschnitte (3c) in das jeweilige Sackloch oder die jeweilige Durchgangsbohrung des dazugehörigen HF-Kontaktanschlusses (5) durch das jeweilige Kontaktmittel (6) hindurch.

9. Verfahren zur HF-Kompensation nach Anspruch 8, wobei die Leiterplatte (1) als eine Verbindung aus einer ersten Leiterplatte (1c) und mindestens einer zweiten Leiterplatte (1d) aufgebaut ist, die miteinander mechanisch verbunden sind und die jeweils mindestens eine Kupferlage aufweisen, wobei die erste Leiterplatte (1c) die Haltekontaktanschlüsse (4) und die Endkontakte (7) und die zweite Leiterplatte (1d) mindestens einen der HF-Kontaktanschlüsse (5) aufweist.

10. Verfahren zur HF-Kompensation nach Anspruch 8 oder 9, wobei die Eintauchtiefe variabel ist.
